# EUROPEAN PATENT APPLICATION

(11) **EP 3 584 873 A1**
(43) Date of publication of application: **25.12.2019**
(21) Application number: 17897078.6
(22) Date of filing: 19.10.2017
(51) Int. Cl.: H01M 10/42, H01M 10/48

(54) **DETERMINATION DEVICE, DETERMINATION METHOD, AND PROGRAM**

(30) Priority: 20.02.2017 JP 2017029309
(71) Applicant: NEC Corporation, Tokyo 108-8001 (JP)
(72) Inventor: KOSUGI Shinichiro, Tokyo 108-8001 (JP); HANAFUSA Hiroshi, Tokyo 108-8001 (JP); TANABE Hideki, Tokyo 108-8001 (JP); MORI Yusuke, Tokyo 108-8001 (JP)
(74) Representative: Betten & Resch
(86) International application number: PCT/JP2017/037821
(87) International publication number: WO 2018/150631

(57) **Abstract**

The present invention provides a determination apparatus (10) having: an acquisition unit (12) that acquires a state value indicating the status of a power storage system; and a determination unit (11) that determines whether or not maintenance has been performed for the power storage system, on the basis of a temporal change of the state value. For example, when the temporal change of the state value is changed from the previous trend, the determination unit (11) determines that maintenance has been performed.

## Description

### TECHNICAL FIELD

The present invention relates to a determination apparatus, a determination method, and a program.

### BACKGROUND ART

Techniques related to the present invention are disclosed in Patent Documents 1 to 3.

Patent Document 1 discloses a storage battery inspection apparatus which is attached to a predetermined apparatus and inspects a state of a storage battery pack capable of supplying power to the predetermined apparatus. The storage battery pack includes a holding unit that holds history information on an operation of the storage battery pack, and a communication terminal for communicating with the predetermined apparatus. The storage battery inspection apparatus is portable, and includes a connection unit that is connectable to the communication terminal of the storage battery pack detached from the predetermined apparatus, a storage unit that stores a state table indicating a correspondence between information on the operation of the storage battery pack and a state of the storage battery pack, a determination unit that acquires the history information held in the holding unit through the connection unit, and determines the state of the storage battery pack by comparing the acquired history information with the information on the operation of the storage battery pack in the state table, and a providing unit that provides a result of the determination.

Patent Document 2 discloses a maintenance work management apparatus that manages a maintenance work for an image forming apparatus performed by a maintenance worker. The maintenance work management apparatus includes a maintenance worker certificate creation unit that creates a certificate of maintenance worker in which maintenance worker information including personal information of the maintenance worker is encrypted using a secret key, and a maintenance worker certificate output unit that outputs the certificate of maintenance worker to an image forming apparatus. The image forming apparatus includes a maintenance worker certificate input unit that inputs the certificate of maintenance worker from the maintenance work management apparatus, an ID card reading unit that reads personal information of the maintenance worker from an ID card carried by the maintenance worker, and a maintenance worker authentication unit that permits transition to a maintenance mode in which the maintenance work can be performed, in a case where the personal information of the maintenance worker information obtained by decrypting the certificate of maintenance worker with a public key matches with the personal information of an ID card.

Patent Document 3 discloses a maintenance management method. The maintenance management method includes a step of registering a device to be regularly inspected in a case where the current installation place information of the device to be inspected is the same as an installation place at a time of contract, or is different from the installation place but the same as a corrected installation place; a step of determining whether a maintenance worker identified from received information on the maintenance worker has maintenance qualification of an apparatus to be maintained with reference to a qualification database and a current location matches an installation location of the apparatus to be maintained; and a step of, in a case of determining as matching, when a maintenance work start time, a maintenance work end time, and maintenance work information are received from a portable terminal, registering the maintenance work start time, the maintenance work end time, and the maintenance work information of the apparatus to be maintained in a third table.

### RELATED DOCUMENT

### PATENT DOCUMENT

[Patent Document 1] Japanese Patent Application Publication No. 2015-127676
[Patent Document 2] Japanese Patent Application Publication No. 2016-192759
[Patent Document 3] Japanese Patent Application Publication No. 2009-187499

### SUMMARY OF THE INVENTION

### TECHNICAL PROBLEM

A power storage system needs regular maintenance. Whether maintenance has been performed affects the probability of failure occurrence and the like. Therefore, persons concerned with the power storage system are required to check whether or not maintenance has been performed. As the persons concerned, for example, an insurance company that provides an insurance product that compensates for the failure of the power storage system, but the present invention is not limited thereto.

Whether or not maintenance has been performed can be checked by, for example, a declaration by the operator or the like of the power storage system, but there is a problem that it cannot be checked whether or not proper maintenance is actually performed.

An object of the present invention is to provide a determination apparatus, a determination method, and a program that solve the above-described problems.

### SOLUTION TO PROBLEM

According to the present invention, there is provided a determination apparatus including
an acquisition unit that acquires a state value indicating a state of a power storage system; and
a determination unit that determines whether or not maintenance has been performed for the power storage system, on the basis of a temporal change of the state value.

Further, according to the present invention, there is provided a determination method executed by a computer, the method including:
an acquisition step of acquiring a state value indicating a state of a power storage system; and
a determination step of determining whether or not maintenance has been performed for the power storage system, on the basis of a temporal change of the state value.

Further, according to the present invention, there is provided a program causing a computer to function as:
an acquisition unit that acquires a state value indicating a state of a power storage system; and
a determination unit that determines whether or not maintenance has been performed for the power storage system, on the basis of a temporal change of the state value.

### ADVANTAGEOUS EFFECTS OF INVENTION

According to the present invention, it is possible to check whether or not maintenance has been performed for a power storage system.

### BRIEF DESCRIPTION OF THE DRAWINGS

The foregoing and other objects, features and advantages will become more apparent from the following description of preferred example embodiments and the accompanying drawings.

Fig. 1 is a diagram conceptually illustrating an example of a hardware configuration of a determination apparatus of the present example embodiment.
Fig. 2 is an example of a functional block diagram of the determination apparatus of the present example embodiment.
Fig. 3 is a diagram for explaining a process of the determination apparatus of the present example embodiment.
Fig. 4 is a flowchart showing an example of a process flow of the determination apparatus of the present example embodiment.
Fig. 5 is a functional block diagram for explaining an application example of the determination apparatus of the present example embodiment.
Fig. 6 is a functional block diagram for explaining an application example of the determination apparatus of the present example embodiment.
Fig. 7 is an example of a functional block diagram of the determination apparatus of the present example embodiment.
Fig. 8 is a diagram for explaining the process of the determination apparatus of the present example embodiment.
Fig. 9 is a diagram for explaining the process of the determination apparatus of the present example embodiment.

### DESCRIPTION OF EMBODIMENTS

### <First Example Embodiment>

First, the outline of a determination apparatus of the present example embodiment will be described. The determination apparatus of the present example embodiment includes a unit that acquires a state value indicating the state of a power storage system; and a unit that determines whether or not maintenance has been performed for the power storage system, on the basis of a temporal change of the state value.

The state of the power storage system gradually deteriorates due to aging deterioration or the like. However, performing maintenance improves the state of the power storage system. The temporal change of the state value indicating the state of the power storage system represents such a change of the state of the power storage system. Therefore, it is possible to determine whether or not maintenance has been performed for the power storage system, on the basis of a temporal change of the state value.

The determination apparatus of the present example embodiment makes it possible to determine whether or not maintenance has been performed for the power storage system, on the basis of objective data "temporal change of the state value indicating the state of the power storage system". Such a determination apparatus of the present example embodiment can provide highly reliable determination results.

Next, the configuration of the determination apparatus will be described. First, an example of a hardware configuration of the determination apparatus will be described. Each functional unit included in the determination apparatus of the present example embodiment is configured with any combination of hardware and software of any computer, mainly using a central processing unit (CPU), a memory, a program to be loaded into the memory, and a storage unit such as a hard disk storing the program (can store programs stored in advance at the stage of shipping the apparatus, and also store programs downloaded from a storage medium such as a compact disc (CD) or a server on the Internet), and a network connection interface. Those skilled in the art will understand that there are various modifications in the configuration methods and apparatuses.

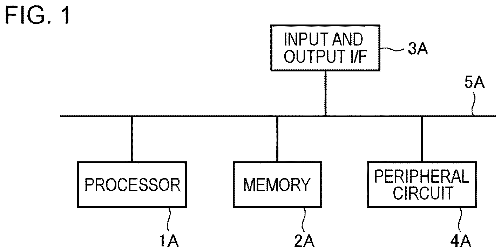

Fig. 1 is a block diagram illustrating a hardware configuration of a determination apparatus of the present example embodiment. As illustrated in Fig. 1, the determination apparatus includes a processor 1A, a memory 2A, an input and output interface 3A, a peripheral circuit 4A, and a bus 5A. The peripheral circuit 4A includes various modules.

The bus 5A is a data transmission path through which the processor 1A, the memory 2A, the peripheral circuit 4A and the input and output interface 3A mutually transmit and receive data. The processor 1A is, for example, an arithmetic processing apparatus such as a central processing unit (CPU) or a graphics processing unit (GPU). The memory 2A is, for example, a memory such as a random access memory (RAM) or a read only memory (ROM). The input and output interface 3A includes an interface for acquiring information from an input apparatus (for example, a keyboard, a mouse, a microphone, a physical key, a touch panel display, and a code reader), an external apparatus, an external server, an external sensor, and the like, and an interface for outputting information to an output apparatus (for example, a display, a speaker, a printer, and a emailer), an external apparatus, an external server, and the like. The processor 1A issues commands to the respective modules and can perform calculation based on the calculation results.

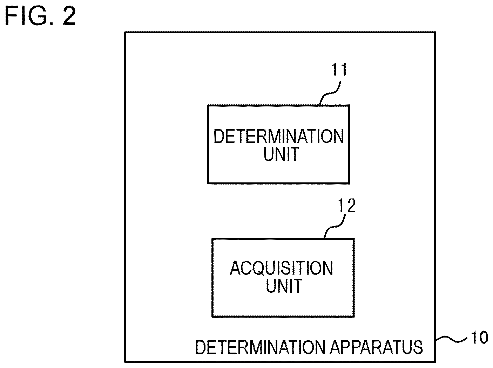

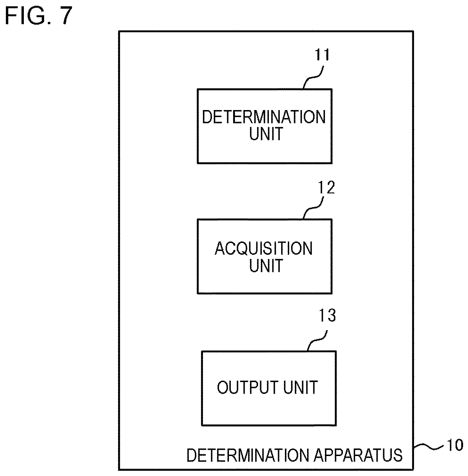

Next, the functional configuration of the determination apparatus will be described. Fig. 2 shows an example of a functional block diagram of the determination apparatus 10. As illustrated, the determination apparatus 10 includes a determination unit 11 and an acquisition unit 12. Fig. 7 shows another example of the functional block diagram of the determination apparatus 10. As illustrated, the determination apparatus 10 may include a determination unit 11, an acquisition unit 12, and an output unit 13.

The acquisition unit 12 acquires a state value indicating a state of a power storage system. The determination unit 11 determines whether or not maintenance has been performed for the power storage system, on the basis of a temporal change of the state value indicating the state of the power storage system.

As the maintenance, replacement of batteries (example: replacement of all batteries, or replacement of a part (a module, a cell, or the like)), addition of battery stacks, cleaning of terminal portions (example: removal of dirt such as carbon), cleaning and replacement of a cooling device (fins or the like), cleaning of intake and exhaust ports, cleaning and replacement of switching elements, replacement of bus bars, and the like are illustrated, but the invention is not limited thereto.

The type of state value corresponds to the maintenance to be determined. In a case where the maintenance to be determined is "replacement of battery", the state value may be, for example, the capacity [kWh] or the output [kW] of the battery of the power storage system. The capacity of the battery of the power storage system decreases with time, but improves (increases) in consequence of the replacement of the battery.

In addition, in a case where the maintenance to be determined is "replacement of battery", the state value may be, for example, a change value (rate of change or change amount) of the capacity of the battery with respect to a temperature change. It is known that when the battery temperature decreases, the capacity of the battery decreases; and when the battery temperature increases, the capacity of the battery increases. When the battery is deteriorated, the change of the capacity of the battery due to the temperature change becomes large. Therefore, the change value of the capacity of the battery with respect to the temperature change increases with time, but improves (decreases) in consequence of the replacement of the battery.

In addition, in a case where the maintenance to be determined is "replacement of battery", the state value may be, for example, the electric power amount [kWh] per state of charge (SOC) of a battery: X [%] (X is greater than 0 and less than 100). The electric power amount [kWh] per SOC of a battery: X [%] decreases with time, but improves (increases) in consequence of the replacement of the battery.

In addition, in a case where the maintenance to be determined is "replacement of battery", the state value may be, for example, a voltage range used in charge and discharge. The voltage range used for charging and discharging increases with time, but when a module or cell that is rapidly deteriorated is selectively replaced or the battery is entirely replaced, the voltage range improves (decreases) accordingly.

In addition, in a case where the maintenance to be determined is "replacement of battery", the state value may be, for example, a temperature change rate per unit time of the power storage system per charge and discharge: Y [kW] (Y is greater than 0) of the power storage system. The temperature change rate per unit time of the power storage system per charge and discharge: Y [kW] (Y is greater than 0) of the power storage system increases with time, but improves (decreases) in consequence of the replacement of the battery.

In addition, in a case where the maintenance to be determined is "cleaning of a terminal portion", the state value may be, for example, an insulation resistance of the power storage system. The battery always has a potential because it is a direct current source. For this reason, dirt such as carbon is likely to adhere to the terminal portion. With the passage of time, the dirt adhering to the terminal portion increases, and the insulation resistance decreases but improves (increases) in consequence of the cleaning of the terminal portion.

In addition, in a case where the maintenance to be determined is "cleaning of a cooling device", the state value may be, for example, a temperature difference between the temperature of the storage battery system and the outside air temperature. If dust adheres to the fan, filter, duct, or the like of the cooling device, the temperature rise of the power storage system becomes large. The dust attached to the cooling device increases with the passage of time, and the temperature difference between the temperature of the storage battery system and the outside air temperature increases but improves (decreases) in consequence of the cleaning of the cooling device.

In addition, in a case where the maintenance to be determined is "cleaning of an intake and exhaust port", the state value may be, for example, a temperature difference between the temperature of the storage battery system and the outside air temperature. Since the power storage system is a stationary device and is installed at the same place for a long time, plants can grow in the vicinity and insects can form a nest. If the intake and exhaust port is blocked due to this, the intake and exhaust performance deteriorates and the temperature rise of the power storage system becomes large. The amount by which intake and exhaust ports are blocked increases with the passage of time, and the temperature difference between the temperature of the storage battery system and the outside air temperature increases but improves (decreases) in consequence of the cleaning of the cooling device.

In addition, in a case where the maintenance to be determined is "replacement of bus bar, replacement of battery (cell), addition of battery", the state value may be, for example, the degree of deviation of output [kW] of the power storage system from the target value [kW]. The power storage system may perform an output operation at a given target value. As the battery and the parts connecting the batteries (bus bars) deteriorate with time, the resistance gradually increases. As the resistance increases, the discharge voltage of the battery decreases, and the degree of deviation increases. The maintenance such as replacement of deteriorated batteries (cells), addition of batteries (parallel connection of battery stacks of the same voltage to reduce apparent resistance), and replacement of bus bars reduces a resistance, and results in a reduction in the degree of deviation.

In addition, in a case where the maintenance to be determined is "cleaning and replacement of a cooling device (fins or the like) and cleaning and replacement of a switching element", the state value may be, for example, the degree of deviation of output [kW] of the power storage system from the target value [kW]. The power storage system may perform an output operation at a given target value. When the performance of the switching element of PCS or the cooling device is deteriorated due to aging deterioration or the like, the temperature of the power storage system gradually increases, and the degree of deviation increases. In some cases, the operation of the power storage system may be stopped. However, if cleaning and replacement of a cooling device (fins or the like) and cleaning and replacement of the switching element are performed, the degree of the deviation improves (is reduced).

The state value may be a measurement value measured by any means. The state value may be a value measured by the power storage system, or may be a value measured by an external apparatus different from the power storage system. The determination apparatus 10 can communicate with these devices by any means, and can acquire the state value (measurement value) from these devices.

When the temporal change of the state value is changed from the previous trend, the determination unit 11 can determine that maintenance has been performed. The trend of the temporal change of the state value increases with time or decreases with time.

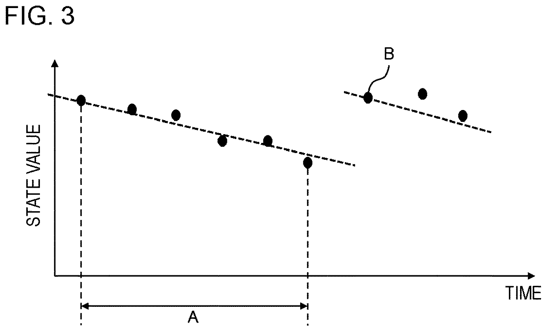

For example, when the change from the previous trend in which the state value decreases with time is detected, the determination unit 11 may determine that maintenance has been performed. Fig. 3 shows an example of a temporal change of the state value. During the period A, a trend in which the state value decreases with time is shown. For example, the battery capacity or the like of the power storage system indicates such a trend. There is a change from the previous decreasing trend, between the state value at the timing B and the state value at a timing immediately before that. In the case of this example, when the state value at the timing B is acquired, the determination unit 11 determines that the temporal change of the state value is changed from the previous trend.

In the case of the example of detecting a change from a decreasing trend, when the state value M1 increases from the previous value M0 (M1 > M0), the determination unit 11 may determine that the trend has changed. In addition, when the state value M1 increases from the previous value M0 by a predetermined level or more (a predetermined value or more, a predetermined ratio or more, or the like) (M1-M0 ≥ T1 > 0), the determination unit 11 may determine that the trend has changed. In addition, in a case where the state value M1 increases from the previous value M0 (or increases by a predetermined level or more) and a predetermined number of state values M2 to Mn thereafter maintain the increased level, the determination unit 11 may determine that the trend has changed. The method of determining whether or not the above level is maintained is a matter of design, but in a case where, for example, a difference between M1 and each of M2 to Mn is smaller than a difference between M0 and each of M2 to Mn, it may be determined that each of M2 to Mn maintains the increased level. In a situation where the state value which is periodically detected gradually decreases in time series (over time), if the state value increases from the previous value, because the trend has changed, it is determined that maintenance has been performed.

In addition, when the change from the previous trend in which the state value increases with time is detected, the determination unit 11 may determine that maintenance has been performed. For example, in a charging system that is charged periodically, the charge and discharge voltage range in the case where constant power is consumed from a full charge state indicates such a trend. In the case of the example of detecting a change from an increasing trend, when the state value M1 decreases from the previous value M0 (M0 > M1), the determination unit 11 may determine that the trend has changed. In addition, when the state value M1 decreases from the previous value M0 by a predetermined level or more (a predetermined value or more, a predetermined ratio or more, or the like) (M0-M1 ≥ T2 > 0), the determination unit 11 may determine that the trend has changed. In addition, in a case where the state value M1 decreases from the previous value M0 (or decreases by a predetermined level or more) and a predetermined number of state values M2 to Mn thereafter maintain the decreased level, the determination unit 11 may determine that the trend has changed. The method of determining whether or not the above level is maintained is a matter of design, but in a case where, for example, a difference between M1 and each of M2 to Mn is smaller than a difference between M0 and each of M2 to Mn, it may be determined that each of M2 to Mn maintains the decreased level. In a situation where the periodically detected state value gradually increases in time series (over time), if the state value decreases from the previous value, because the trend has changed, it is determined that maintenance has been performed.

It should be noted that, the determination unit 11 may detect the trend of the temporal change of each state value, on the basis of the acquired state value. In addition, as described above, in accordance with the type of the state value, the trend of the temporal change of the state value (the trend of the change of the state value according to the aging deterioration) is known in advance. Therefore, in the storage unit of the determination apparatus 10, information indicating the content of the trend (hereinafter, sometimes referred to as "trend information") may be stored in advance for each type of state value. Further, the acquisition unit 12 (see Fig. 7) of the determination apparatus 10 may acquire trend information from the storage unit. Then, the determination unit 11 may recognize the trend of the temporal change of each state value on the basis of trend information, and determine, on the basis of the trend, whether or not maintenance has been performed. It should be noted that, the trend information may be stored in an external apparatus or a power storage system other than the determination apparatus 10. Then, the acquisition unit 12 may optionally communicate with a communication unit to acquire trend information from the external apparatus or the power storage system.

Here, "acquisition" includes at least one of acquiring data or information stored in another apparatus or storage medium performed by an apparatus (active acquisition), for example, requesting or querying to another apparatus and receiving data or information, accessing another apparatus and storage media to read data or information, or the like, and inputting data or information output from another apparatus to the apparatus (passive acquisition), for example, receiving data or information delivered (or transmitted, push-notified, or the like). It also includes selectively acquiring data or information from the received data or information, or selectively receiving data or information from the distributed data or information.

It should be noted that, the acquisition unit 12 may acquire a plurality of types of state values. Then, the determination unit 11 may determine the change of the trend in each of the plurality of types of state values, and determine whether or not each of the plurality of types of maintenance has been performed, on the basis of the result. In this case, the determination unit 11 may determine which maintenance has been performed, on the basis of changes in trends of the plurality of types of state values. For example, information for identifying the executed maintenance may be associated in advance with each combination of state values in which the trend has changed (one state value or a combination of a plurality of state values). Then, the determination unit 11 may determine the executed maintenance, on the basis of the determination result of the change in the trend of each state value and correspondence information indicating which maintenance has been performed from the change in the trend of the plurality of types of state values.

For example, in a case where the trends of the insulation resistance of the battery and the battery voltage change, the determination unit 11 may determine that the battery has been replaced or the terminal has been cleaned. In addition, in a case where the trends of the PCS DC voltage and the battery voltage change, the determination unit 11 may determine that the component of the battery connector has been replaced. In addition, in a case where the trends of the battery temperature and the pressure in the housing change, the determination unit 11 may determine that the battery cooling device has been cleaned. In addition, when the trends of the battery current and the battery voltage change, the determination unit 11 may determine that the battery has been replaced in order to improve the battery deterioration (increase in resistance). In addition, when the trends of the AC current of the PCS and the battery current change, the determination unit 11 may determine that the current-measuring device has been replaced in order to improve the failure of the current-measuring device. It should be noted that, in a case where a predetermined maintenance item is determined in advance and the trend of a predetermined state value changes, it is not necessary to determine maintenance from changes in trends of a plurality of state values, or the like, and it is also possible to estimate that maintenance determined in advance has been performed.

In addition, the acquisition unit 12 may acquire one type of state value. Then, the determination unit 11 may determine the change of the trend of the state value, and determine whether or not one type of maintenance has been performed on the basis of the result.

Next, execution timings of the acquisition of the state value by the acquisition unit 12 and the determination by the determination unit 11 will be described.

### "Timing Example 1"

The acquisition unit 12 may periodically acquire the state value at a predetermined time interval T1. Then, the determination unit 11 may determine whether or not there is a change in trend, on the basis of the state values accumulated so far and the newly acquired state value, each time the acquisition unit 12 acquires the state value, or at a time interval longer than the time interval T1. That is, the determination unit 11 may determine whether there is a change in the trend, periodically at the time interval T1 or periodically at a time interval longer than the time interval T1. Although for example, one day, one week, one month, several months, one year, or the like is illustrated as the time interval T1, but the present invention is not limited thereto. It should be noted that, in a case where a plurality of types of state values are acquired, the state values may be acquired at time intervals T1 different for each type of state value, and the determination may be performed at different time intervals.

### "Timing Example 2"

The acquisition unit 12 may acquire a plurality of state values at predetermined time intervals T1 within a predetermined determination period T2 including a predetermined maintenance execution timing. It should be noted that, the acquisition unit 12 may collectively acquire a plurality of state values at the predetermined time intervals T1 within the determination period T2. The acquisition unit 12 may not acquire the state value in a period other than the determination period T2. Then, the determination unit 11 may determine whether the temporal change of the state value in the determination period T2 is changing from the trend of the temporal change of the state value before the determination period T2. The trend of the temporal change of the state value before the determination period T2 is determined on the basis of the type of the state value. For example, in a case where the execution timing of a certain maintenance is February 7, 2017, the determination period T2 may be from February 3, 2017 to February 11, 2017. That is, it may be determined whether it is changing from the trend of the temporal change of the state value from February 3, 2017 to February 11, 2017. It should be noted that, the determination period T2 is just an example, and the present invention is not limited thereto. Although for example, 15 minutes, 30 minutes, one hour, one day or the like is illustrated as the time interval T1 of the example, but the present invention is not limited thereto.

### "Timing Example 3"

In Timing Example 2, the execution timing of the maintenance is determined in advance, but in Timing Example 3, the execution timing of the maintenance is variable. In this case, when the maintenance schedule is determined, an arbitrary user (example: a person concerned with maintenance) inputs maintenance information including a scheduled execution timing of maintenance to the determination apparatus 10 by any means.

The acquisition unit 12 may acquire a plurality of state values at predetermined time intervals T1, within a predetermined determination period T2 including a scheduled execution timing of maintenance indicated by the maintenance information. It should be noted that, the acquisition unit 12 may collectively acquire a plurality of state values at the predetermined time intervals T1 within the determination period T2. The acquisition unit 12 may not acquire the state value in a period other than the determination period T2. Then, the determination unit 11 may determine whether the temporal change of the state value in the determination period T2 is changing from the trend of the temporal change of the state value before the determination period T2. The trend of the temporal change of the state value before the determination period T2 is determined on the basis of the type of the state value. For example, in a case where the scheduled execution timing of a certain maintenance is February 7, 2017, the determination period T2 may be from February 3, 2017 to February 11, 2017. That is, it may be determined whether it is changing from the trend of the temporal change of the state value, from February 3, 2017 to February 11, 2017. It should be noted that, the determination period is just an example, and the present invention is not limited thereto. Although for example, 15 minutes, 30 minutes, one hour, one day or the like is illustrated as the time interval T1 of the example, but the present invention is not limited thereto.

### "Timing Example 4"

In this example, it is assumed that the state value is periodically measured at a predetermined time interval T3 and accumulated in a predetermined storage device. The predetermined storage device may be a storage device installed at a center that manages a plurality of power storage systems 3, a storage device installed locally corresponding to each of the plurality of power storage systems 3, or others. Then, the acquisition unit 12 acquires a predetermined state value, from among the state values accumulated in the storage device. Although for example, 15 minutes, 30 minutes, one hour, one day or the like is illustrated as the time interval T3, but the present invention is not limited thereto.

The acquisition unit 12 receives a notification (maintenance information) indicating the start and/or the end of maintenance by any means. For example, a person who performs maintenance may input a notification indicating the start and/or the end of maintenance through any terminal apparatus at the start timing and/or the end timing of the maintenance. Then, in accordance with the input, a notification (maintenance information) indicating the start and/or the end of maintenance may be transmitted to the determination apparatus 10.

The acquisition unit 12 may acquire a plurality of state values at predetermined time intervals T1 within the predetermined determination period T2 including the start timing and/or the end timing of maintenance from the storage device. It should be noted that, the acquisition unit 12 may collectively acquire a plurality of state values at the predetermined time intervals T1 within the determination period T2. The acquisition unit 12 may not acquire the state value in a period other than the determination period T2. Then, the determination unit 11 may determine whether the temporal change of the state value in the determination period T2 is changing from the trend of the temporal change of the state value before the determination period T2. The trend of the temporal change of the state value before the determination period T2 is determined on the basis of the type of the state value.

For example, in a case where the start timing of a certain maintenance is 13:05 on February 7, 2017 and the end timing is 16:45 on February 7, 2017, the determination period T2 may be from 0:00 on February 6, 2017 to 20:00 on February 7, 2017. It should be noted that, the determination period T2 is just an example, and the present invention is not limited thereto. Although for example, 15 minutes, 30 minutes, one hour, one day or the like is illustrated as the time interval T1 of the example, but the present invention is not limited thereto. The time interval T1 and the time interval T3 may be the same value or different values.

It should be noted that, even in Timing Examples 1 to 3 and Timing Example 5 described below, the acquisition unit 12 may acquire the state values accumulated in the storage device from the storage device.

### "Timing Example 5"

In this example, acquisition of the state value by the acquisition unit 12 and determination by the determination unit 11 are performed at two or more timings in Timing Examples 1 to 4.

It should be noted that, the maintenance information in Timing Examples 3 and 4 above may include time information such as a scheduled maintenance timing, maintenance start/end timings, and a maintenance completed time. Then, the determination unit 11 may determine whether maintenance has been performed, from the change in the trend of the state acquired by the acquisition unit 12 at the timing or time corresponding to the time information. In the case of the maintenance schedule information, the determination may be made by acquiring the state value from the power storage system in real time at that time, or the determination may be made later by acquiring the state value at the time from the storage device in the inside or the outside. In the case of the information on execution completion, the determination may be made by acquiring the state value at the time from the storage device regardless of inside or outside.

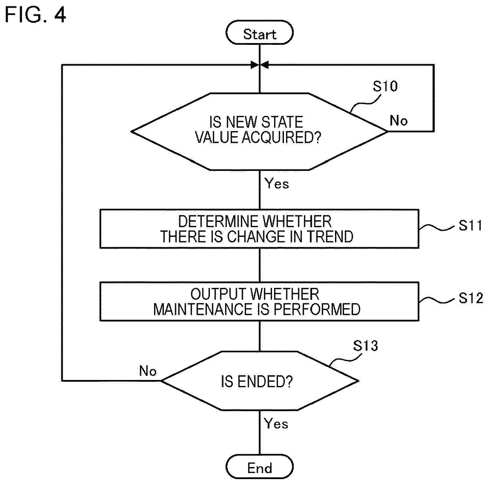

Next, an example of the process flow of the determination apparatus 10 of the present example embodiment will be described with reference to the flowchart of Fig. 4.

The acquisition unit 12 waits for a new state value until acquiring a new state value (No in S10). When the acquisition unit 12 acquires a new state value (Yes in S10), the determination unit 11 determines whether the temporal change of the state value has changed from the previous trend (S11). The details of the determination process by the determination unit 11 are as described above.

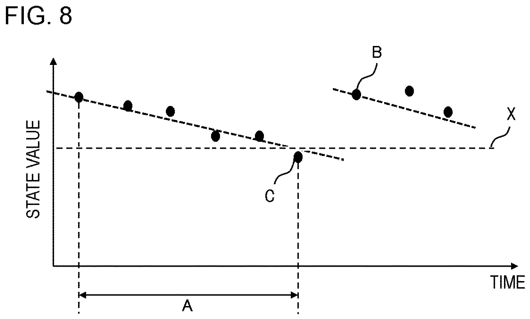

After S11, the output unit 13 (see Fig. 8) outputs whether or not maintenance has been performed. In a case where it is determined in S11 that the temporal change of the state value has changed from the previous trend, the output unit 13 outputs that maintenance has been performed. On the other hand, in a case where it is determined in S11 that the temporal change of the state value has not changed from the previous trend, the output unit 13 outputs that maintenance has not been performed.

The output unit 13 may output the determination result made by the determination unit 11 to the inside of the determination apparatus or an external apparatus. For example, the output unit 13 may output, to the storage device of the determination apparatus 10 or the external apparatus, information indicating whether or not maintenance has been performed. Then, the information indicating whether or not maintenance has been performed may be accumulated in the storage device. Further, the output unit 13 may transmit the information indicating whether or not maintenance has been performed, using an e-mail address registered in advance as a transmission destination.

According to the determination apparatus 10 of the present example embodiment described above, it is possible to determine whether or not maintenance has been performed for the power storage system, on the basis of objective data "temporal change of the state value indicating the state of the power storage system". According to the determination apparatus 10 of the present example embodiment, highly reliable determination results can be provided.

For example, in the case of an insurance product that compensates for a failure of the power storage system, non-execution of maintenance can be a disclaimer. According to the determination apparatus 10 of the present example embodiment, useful information can be provided to an insurance company that provides the insurance product.

Further, according to the determination apparatus 10 of the present example embodiment, it is possible to determine whether maintenance is performed for the power storage system, on the basis of values for which measurement means are widely provided, such as a battery capacity, an insulation resistance, a temperature difference between the temperature of the storage battery system and an outside air temperature, a change value of the battery capacity with respect to the temperature change, the electric power amount per SOC of a battery: X [%] (X is greater than 0 and less than 100), a voltage range used in charge and discharge, a temperature change rate per unit time of the power storage system per charge and discharge of the power storage system: Y [kW] (Y is greater than 0), and the degree of deviation of output [kW] of the power storage system from the target value [kW]. Therefore, it can be realized relatively easily.

Further, according to the determination apparatus 10 of the present example embodiment, the executed maintenance can be determined on the basis of the type of the state value in which the trend has changed.

### <Second Example Embodiment>

A determination apparatus 10 of the present example embodiment is different from the first example embodiment in that the determination apparatus 10 has a function of determining whether or not maintenance is performed so as to satisfy a predetermined temporal condition, in addition to the functions of the first example embodiment.

An example of the hardware configuration of the determination apparatus 10 of the present embodiment is the same as that of the first example embodiment, and thus the description thereof is omitted here.

Next, the functional configuration of the determination apparatus 10 will be described. An example of the functional block diagram of the determination apparatus 10 of the present exemplary embodiment is illustrated in Fig. 2 or Fig. 7, as in the first example embodiment. The configuration of the acquisition unit 12 is the same as in the first example embodiment. The determination unit 11 and the output unit 13 have functions described below, in addition to or instead of the functions described in the first example embodiment.

The determination unit 11 can determine whether or not maintenance has been performed for the power storage system, as in the first example embodiment. It should be noted that, the determination result of the determination unit 11 may be associated with information indicating the determination date and time.

Then, on the basis of the result of determination as to whether maintenance has been performed for the power storage system, the determination unit 11 determines whether or not maintenance is performed so as to satisfy a predetermined temporal condition.

For example, acquisition of the state value by the acquisition unit 12 and determination by the determination unit 11 may be performed in any one or more of Timing Examples 1 to 5 described in the first example embodiment. Then, on the basis of the determination result, the determination unit 11 may determine whether or not the execution of the maintenance satisfies a temporal condition (for example, once a month, once a year, once every three years, or the like).

In addition, the acquisition unit 12 may periodically acquire the state value at a predetermined time interval T1. Then, the determination unit 11 may determine whether or not it is a state where the power storage system requires maintenance, on the basis of the newly acquired state value, each time the acquisition unit 12 acquires the state value or at a time interval longer than time interval T1. Then, in a case where the determination unit 11 determines that maintenance is required, the determination unit 11 may determine whether or not maintenance is performed within a predetermined period T4 after the determination (so as to satisfy a temporal condition).

In this case, the acquisition unit 12 may acquire a plurality of state values at predetermined time intervals T1' within a predetermined determination period T2 after it is determined that maintenance is required. It should be noted that, the acquisition unit 12 may collectively acquire a plurality of state values at the predetermined time intervals T1 within the determination period T2. Then, the determination unit 11 may determine whether the temporal change of the state value in the determination period T2 is changing from the trend of the temporal change of the state value before the determination period T2. The trend of the temporal change of the state value before the determination period T2 is determined on the basis of the type of the state value.

It should be noted that, T2 ≥ T4 is satisfied. That is, the determination period T2 includes the predetermined period T4 indicated by the above-described temporal condition. Further, T1 > T1' is satisfied. That is, in the determination period T2, the acquisition unit 12 makes the time interval for acquiring the state value smaller than in the other periods. Although for example, one hour, one day, or the like is illustrated as the time interval T1 of the example, but the present invention is not limited thereto. Although for example, 15 minutes, 30 minutes, 1 hour, or the like is illustrated as the time interval T1' of the example, but the present invention is not limited thereto.

Further, in this case, when the determination unit 11 determines that the power storage system requires maintenance, the output unit 13 may request the user to perform maintenance within the predetermined period T4. The request to the user may be performed by transmitting an e-mail to a pre-registered transmission destination, or may be performed by an output through the power storage system, the determination apparatus 10 or a display, a warning lamp, a speaker, or the like of these devices.

It should be noted that, the determination unit 11 may set the predetermined period T4 according to the difference between the newly acquired state value and the reference value. Then, the output unit 13 may request execution of maintenance within the predetermined period T4 set according to the difference between the newly acquired state value and the reference value. As the difference is larger, the predetermined time T4 decreases.

In addition, before it is determined that maintenance is required, the acquisition unit 12 may change the time interval T1, on the basis of the difference between the state value and the reference value. Specifically, the acquisition unit 12 may reduce the time interval T1, as the difference between the state value and the reference value decreases (as the state value approaches the reference value). In addition, before it is determined that maintenance is required, the determination unit 11 may change the time interval to determine whether maintenance is required, on the basis of the difference between the state value and the reference value. Specifically, the determination unit 11 may reduce the time interval, as the difference between the state value and the reference value decreases (as the state value approaches the reference value).

Here, a process in which the determination unit 11 determines whether or not the power storage system requires maintenance on the basis of the state value will be described.

When the state value with a trend in which the value decreases with the passage of time falls below the reference value, the determination unit 11 may determine that the maintenance corresponding to the state value is required. On the other hand, while the state value exceeds the reference value, it may be determined that the maintenance corresponding to the state value is not required.

Fig. 8 shows the temporal change of the state value representing the trend and an example of the reference value. During the period A, a trend in which the state value decreases with time is shown. Then, the state value at the timing C is less than the reference value X. In such a case, when acquiring the state value at the timing C, the determination unit 11 determines that maintenance is required. Then, when the state values prior thereto shown in the drawing are acquired, it is determined that the state does not require maintenance. It should be noted that, as described above, between the state value at the timing B and the state value at the timing C immediately before that, there is a change from the previous decreasing trend. In the case of this example, when acquiring the state value at the timing B, the determination unit 11 determines that the temporal change of the state value has changed from the previous trend, that is, maintenance has been performed.

In addition, when the state value with a trend in which the value increases with the passage of time exceeds the reference value, the determination unit 11 may determine that the maintenance corresponding to the state value is required. On the other hand, while the state value falls below the reference value, it may be determined that the maintenance corresponding to the state value is not required.

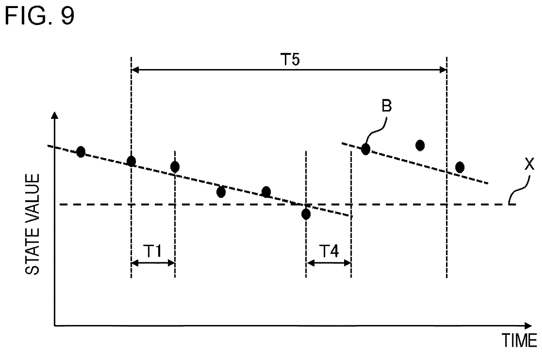

Here, an example will be described with reference to Fig. 9. The acquisition unit 12 acquires the state value at a time interval T1 shorter than the maintenance time interval T5, at which the maintenance should be performed periodically. Then, the determination unit 11 determines the necessity of maintenance at, for example, the time interval T1 or a time interval longer than the time interval T1 (shorter than T5). The necessity for maintenance can be determined by comparing the state value with the reference value, as described above. Then, in a case where it is determined by the determination unit 11 that maintenance is required, it is assumed that maintenance is required to be performed within a predetermined period T4. The predetermined period T4 may be determined in advance for each type of maintenance. Further, it may be determined according to the magnitude of the difference between the state value and the reference value. Then, the output unit 13 outputs, to the user, a request for maintenance within the predetermined period T4. In the predetermined period T4, the acquisition unit 12 acquires the state value at a time interval T1' shorter than the time interval T1.

It should be noted that, the magnitude relationship between T1, T1', T4, and T5 is that T5 > T1 ≥ T4 > T1' or T5 > T4 > T1 > T1'. T5 is, for example, one year. T1 is, for example, one month. T4 is, for example, two weeks, one month or two months. T1' is, for example, 15 minutes, 30 minutes, one hour, or one day. It should be noted that, the illustration of the values of T1, T1', T4, and T5 here is just an example, and the present invention is not limited thereto.

The predetermined period T4 may be one fixed value given for each type of maintenance, or may be a variable value which varies according to the state value.

As an example of the variable value, for example, a value determined according to the degree of deviation between the state value and the reference value is illustrated. In the case of an example requiring maintenance when the state value falls below the reference value, the predetermined period T4 is given according to the degree of deviation of the state value which falls below the reference value from the reference value. In the case of an example requiring maintenance when the state value exceeds the reference value, the predetermined period T4 is given according to the degree of deviation of the state value which exceeds the reference value from the reference value. The larger the degree of deviation, the shorter the predetermined period T4 is given.

As another example of the variable value, a value determined according to the magnitude of the change amount of the state value with respect to the elapsed time is illustrated. As the change amount of the state value with respect to the elapsed time is larger, that is, as the speed of deterioration is larger, a shorter predetermined period T4 is given.

According to the determination apparatus 10 of the present example embodiment described above, the same advantageous effects as that of the first example embodiment can be realized.

Further, according to the determination apparatus 10 of the present example embodiment, it can be determined whether or not the maintenance is performed so as to satisfy a predetermined temporal condition. In order to suppress the failure occurrence probability of the power storage system, it is necessary not only to simply maintenance but also to perform maintenance at an appropriate timing. According to the present example embodiment, it is possible to determine whether or not maintenance has been performed for the power storage system, on the basis of objective data "temporal change of the state value indicating the state of the power storage system", and further determine whether or not maintenance has been performed at an appropriate timing, on the basis of the result. According to the determination apparatus 10 of the present example embodiment, highly reliable determination results can be provided.

For example, in the case of an insurance product that compensates for a failure of the power storage system, "not performing maintenance that satisfies a predetermined temporal condition" can be a disclaimer. According to the determination apparatus 10 of the present example embodiment, useful information can be provided to an insurance company that provides the insurance product.

### <Application Examples>

Next, an application example of the determination apparatus 10 of the first and second example embodiments will be described.

### "Application Example 1"

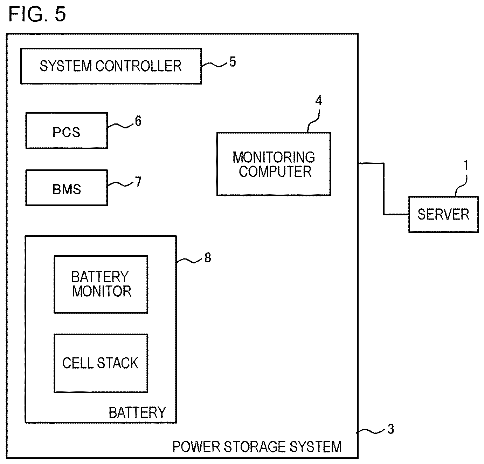

The server 1 and the power storage system 3 are shown in the functional block diagram of Fig. 5. In Application Example 1, the server 1 has the function of the determination apparatus 10. That is, the server 1 determines whether or not maintenance has been performed for the power storage system, on the basis of a temporal change of the state value indicating the state of the power storage system.

The server 1 and the power storage system 3 are connected through a network such as the Internet to mutually transmit and receive information. The server 1 may be a cloud server.

The power storage system 3 includes a monitoring computer 4, a system controller 5, a power conditioning system (PCS) 6, a battery management system (BMS) 7, and a battery 8.

The system controller 5 controls the entire power storage system 3. The PCS 6 performs conversion of DC power/AC power. The battery 8 stores electric power. The battery 8 includes, for example, a cell stack that stores energy, a battery monitor that monitors cell temperature, cell voltage, or the like. The BMS 7 controls the battery 8. The monitoring computer 4 acquires various measurement values, from at least one of the system controller 5, the PCS 6, the BMS 7, and the battery 8. Then, the monitoring computer 4 transmits a part or all of the measurement values to the server 1 (determination apparatus 10) as the above-described state value.

### "Application Example 2"

The server 1 and the power storage system 3 are shown in the functional block diagram of Fig. 5. In Application Example 2, the monitoring computer 4 of the power storage system 3 has the functions of the determination apparatus 10. That is, the monitoring computer 4 of the power storage system 3 determines whether or not maintenance has been performed for the power storage system, on the basis of a temporal change of the state value indicating the state of the power storage system.

The server 1 and the power storage system 3 are connected through a network such as the Internet to mutually transmit and receive information. The server 1 may be a cloud server.

The power storage system 3 includes a monitoring computer 4, a system controller 5, a PCS 6, a BMS 7, and a battery 8. The functions of the system controller 5, the PCS 6, the BMS 7, and the battery 8 are the same as in Application Example 1.

The monitoring computer 4 (determination apparatus 10) acquires various measurement values, from at least one of the system controller 5, the PCS 6, the BMS 7, and the battery 8. Then, the monitoring computer 4 processes a part or all of the measured values as the above-described state value, and determines whether or not maintenance has been performed for the power storage system, and whether or not a temporal condition is satisfied. Then, the monitoring computer 4 transmits the determination result to the server 1. The server 1 stores the received determination result in association with each power storage system 3.

### "Application Example 3"

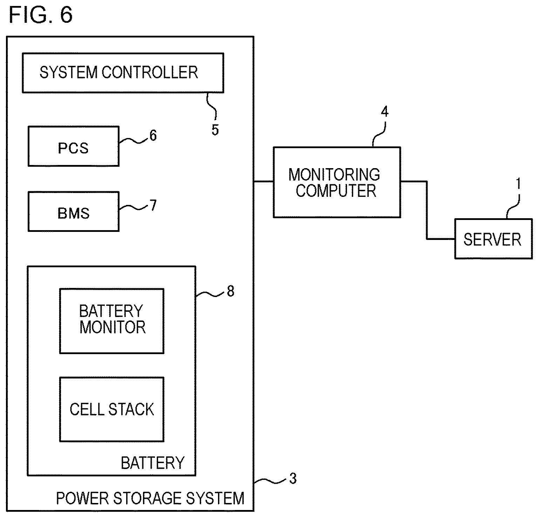

A functional block diagram of Application Example 3 is shown in Fig. 6. Application Example 3 differs from Application Example 1 in that the monitoring computer 4 is provided outside the power storage system 3. Others are the same as in Application Example 1. In Application Example 3, the server 1 has the function of the determination apparatus 10. That is, the server 1 determines whether or not maintenance has been performed for the power storage system, on the basis of a temporal change of the state value indicating the state of the power storage system.

### "Application Example 4"

A functional block diagram of Application Example 4 is shown in Fig. 6. Application Example 4 differs from Application Example 2 in that the monitoring computer 4 is provided outside the power storage system 3. Others are the same as in Application Example 2. In Application Example 4, the monitoring computer 4 provided outside the power storage system 3 has the functions of the determination apparatus 10. That is, the monitoring computer 4 provided outside the power storage system 3 determines whether or not maintenance has been performed for the power storage system, on the basis of a temporal change of the state value indicating the state of the power storage system.

Examples of a reference aspect will be added below.
1. A determination apparatus including:
   an acquisition unit that acquires a state value indicating a state of a power storage system; and
   a determination unit that determines whether or not maintenance has been performed for the power storage system, on the basis of a temporal change of the state value.
2. The determination apparatus according to 1, in which when the temporal change of the state value is changed from a previous trend, the determination unit determines that the maintenance has been performed.
3. The determination apparatus according to 1,
   in which when the temporal change of the state value in a determination period changes from a trend of the temporal change of the state value before the determination period, the determination unit determines that the maintenance has been performed in the determination period.
4. The determination apparatus according to any one of 1 to 3,
   in which the determination unit determines whether or not the maintenance is performed so as to satisfy a predetermined temporal condition.
5. The determination apparatus according to 4,
   in which the determination unit
   determines whether or not the power storage system requires the maintenance, on the basis of the state value, and
   determines whether or not the maintenance is performed within a predetermined period of time after it is determined that the maintenance is required.
6. The determination apparatus according to 5,
   in which when the state value exceeds or falls below a reference value, the determination unit determines that the maintenance is required.
7. The determination apparatus according to 5 or 6, further including:
   an output unit that requests execution of the maintenance within the predetermined period when the determination unit determines that the power storage system requires the maintenance.
8. The determination apparatus according to any one of 5 to 7,
   in which the determination unit sets the predetermined period shorter as a difference between the state value and the reference value is larger.
9. The determination apparatus according to 7,
   in which the output unit requests execution of the maintenance in the predetermined period which is shorter as a difference between the state value and the reference value is larger.
10. The determination apparatus according to any one of 1 to 9,
   in which when the maintenance information is input, the acquisition unit acquires the state value of a period determined specified by the maintenance information, and
   in which the determination unit determines whether or not the maintenance has been performed for the power storage system, on the basis of a temporal change of the state value.
11. The determination apparatus according to any one of 1 to 10,
   in which the acquisition unit acquires state values at predetermined time intervals, and
   in which the determination unit determines whether or not the maintenance is performed at the predetermined time intervals.
12. The determination apparatus according to any one of 1 to 11,
   in which the acquisition unit acquires a plurality of types of state values, and in which the determination unit determines which maintenance has been performed, on the basis of changes in trends of the plurality of types of state values.
13. The determination apparatus according to any one of 1 to 12,
   in which the determination unit uses, as the state value, at least one of a battery capacity, an insulation resistance, a temperature difference between a temperature of the power storage system and an outside air temperature, a change value of the battery capacity with respect to a temperature change, an electric power amount per state of charge (SOC) of a battery: X [%] (X is greater than 0 and less than 100), a voltage range used in charge and discharge, and a temperature change rate per unit time of the power storage system per charge and discharge Y [kW] (Y is greater than 0) of the power storage system.
14. A determination method which is performed by a computer, the method including:
   an acquisition step of acquiring a state value indicating a state of a power storage system; and
   a determination step of determining whether or not maintenance has been performed for the power storage system, on the basis of a temporal change of the state value.
15. A program causing a computer to function as:
   an acquisition unit that acquires a state value indicating a state of a power storage system; and
   a determination unit that determines whether or not maintenance has been performed for the power storage system, on the basis of a temporal change of the state value.

This application claims priority based on Japanese Patent Application No. 2017-029309 filed on February 20, 2017, and the disclosure of which is incorporated herein in its entirety.

## Claims

1. A determination apparatus comprising:
an acquisition unit that acquires a state value indicating a state of a power storage system; and
a determination unit that determines whether or not maintenance has been performed for the power storage system, on the basis of a temporal change of the state value.

2. The determination apparatus according to claim 1,
wherein when the temporal change of the state value is changed from a previous trend, the determination unit determines that the maintenance has been performed.

3. The determination apparatus according to claim 1,
wherein when the temporal change of the state value in a determination period changes from a trend of the temporal change of the state value before the determination period, the determination unit determines that the maintenance has been performed in the determination period.

4. The determination apparatus according to any one of claims 1 to 3,
wherein the determination unit determines whether or not the maintenance is performed so as to satisfy a predetermined temporal condition.

5. The determination apparatus according to claim 4,
wherein the determination unit
determines whether or not the power storage system requires the maintenance, on the basis of the state value, and
determines whether or not the maintenance is performed within a predetermined period of time after it is determined that the maintenance is required.

6. The determination apparatus according to claim 5,
wherein when the state value exceeds or falls below a reference value, the determination unit determines that the maintenance is required.

7. The determination apparatus according to claim 5 or 6, further comprising:
an output unit that requests execution of the maintenance within the predetermined period when the determination unit determines that the power storage system requires the maintenance.

8. The determination apparatus according to any one of claims 5 to 7,
wherein the determination unit sets the predetermined period shorter as a difference between the state value and the reference value is larger.

9. The determination apparatus according to claim 7,
wherein the output unit requests execution of the maintenance in the predetermined period which is shorter as a difference between the state value and the reference value is larger.

10. The determination apparatus according to any one of claims 1 to 9,
wherein when maintenance information is input, the acquisition unit acquires the state value of a period determined specified by the maintenance information, and
wherein the determination unit determines whether or not the maintenance has been performed for the power storage system, on the basis of a temporal change of the state value.

11. The determination apparatus according to any one of claims 1 to 10,
wherein the acquisition unit acquires state values at predetermined time intervals, and
wherein the determination unit determines whether or not the maintenance is performed at the predetermined time intervals.

12. The determination apparatus according to claim 11,
wherein as a difference between the state value and a reference value is smaller, the time interval is decreased.

13. The determination apparatus according to any one of claims 1 to 12,
wherein the acquisition unit acquires a plurality of types of state values, and
wherein the determination unit determines which maintenance has been performed, on the basis of changes in trends of the plurality of types of state values.

14. The determination apparatus according to any one of claims 1 to 13,
wherein the determination unit uses, as the state value, at least one of a battery capacity, an insulation resistance, a temperature difference between a temperature of the power storage system and an outside air temperature, a change value of the battery capacity with respect to a temperature change, an electric power amount per state of charge (SOC) of a battery: X [%] (X is greater than 0 and less than 100), a voltage range used in charge and discharge, and a temperature change rate per unit time of the power storage system per charge and discharge Y [kW] (Y is greater than 0) of the power storage system.

15. A determination method which is performed by a computer, the method comprising:
an acquisition step of acquiring a state value indicating a state of a power storage system; and
a determination step of determining whether or not maintenance has been performed for the power storage system, on the basis of a temporal change of the state value.

16. A program causing a computer to function as:
an acquisition unit that acquires a state value indicating a state of a power storage system; and
a determination unit that determines whether or not maintenance has been performed for the power storage system, on the basis of a temporal change of the state value.
